# EUROPEAN PATENT APPLICATION

(11) **EP 1 677 087 A1**
(43) Date of publication of application: **05.07.2006**
(21) Application number: 04447285.0
(22) Date of filing: 21.12.2004
(51) Int. Cl.: G01K 7/02, H01L 35/12

(54) **Thermocouple assembly and method of use**

(71) Applicant: VESUVIUS CRUCIBLE COMPANY, Wilmington, Delaware 19803 (US)
(72) Inventor: Robbins, Bernard, Altrincham Cheshire WA15 6JN (GB); Farrell, David, Urmston Manchester M41 9EW (GB); Rush, David L., Worksop Nottinghamshire S81 7LE (GB)
(74) Representative: Debled, Thierry

(57) **Abstract**

The invention relates to a thermocouple assembly for the continuous measurement of the temperature of a molten phase comprising
- first and second ceramic elements (1,2) contacting each other at a first junction (3) and forming thereby a first thermocouple,
- a second thermocouple formed of two different conducting elements (4,5) contacting each other at a second junction (6) located on the first ceramic element (1) and
- a third thermocouple formed of two different conducting elements (7,8) contacting each other at a third junction (9) located on the second ceramic element (2),
wherein both positive legs (4,7) or both negative legs (5,8) of the second and third thermocouples are connected to a first measuring device (10), while both legs (4,5;7,8) of the second and third thermocouple are connected respectively to a second and third measuring device (11,12) as well as to a process for the measurement of the temperature of a molten phase.

## Description

The present invention concerns a thermocouple assembly for the measurement of the temperature of a molten phase (or other high temperature applications) and to a method for the measurement of the temperature of a molten phase (or other high temperature applications) using the said thermocouple assembly.

It is known that dissimilar materials, when joined produce an electromotive force by the Seebeck effect in relation to the temperature of the junction between the materials. Thermocouple constituted of metals are known and largely used for decades. Unfortunately, the metals used for these thermocouple have a tendency to oxidise or to be chemically attacked during use so that their accuracy is not guaranteed over extended periods. It has already been described that certain non-metallic materials, for example ceramics, may also produce an electromotive force in relation to their temperature. Ceramics do not suffer the above disadvantages.

GB 2,288,908 or US 4,450,314 for example disclose ceramic thermocouple assemblies for the measurement of the temperature of a molten phase and other high temperature applications. These thermocouple assemblies consist of first and second ceramic elements contacting each other at a junction wherein one of the ceramic elements is urged against the other.

It has now been realised that, although this ceramic assembly was already a significant step forward in the art, the accuracy of the temperature measurement still needs to improve for some particular applications. For certain very demanding applications like continuous casting of steel, hot pressing or manufacture of a glass ribbon at the surface of a tin bath, it is indeed required to monitor continuously and accurately temperatures as high as 2000°C.

The main problem arises from the fact that the cold junctions at the "cold ends" of the first and second ceramic elements, where electrical measurements are made, can themselves produce electromotive forces of sufficient magnitude to introduce significant errors in the measurement process and these errors increase with increasing junction temperature. Since constraints are indeed imposed on the manufacture and costs, long ceramic thermocouple cannot be fabricated. Consequently, the "cold ends" are relatively close to the hot junction and are also subject to relatively high temperatures. Thereby, significant electromotive forces are also generated at the "cold ends" ceramic / metal junctions. These electromotive forces, which will alter the reading at the electromotive force readout meter, are variable with the temperature so that an accurate continuous measurement of the temperature at the hot junction cannot be determined. For example, it has been measured that for a silicon carbide/molybdenum disilicide thermocouple operated at only 150°C, an increase of 10°C at the "cold ends" would results in a final temperature determination lower by around 10°C. In the scope of the present application, the expression "cold ends" designates the ends of the first and second ceramic elements which are opposite to their junction (hot junction).

Cold junction compensation has already been proposed in the art. Various attempts have been made such as cooling of the cold ends (unfortunately, cooling of the cold ends may also affect the temperature at the hot end or can simply be impractical), use of electronic circuits generating an electromotive force nullifying the electromotive forces generated at the "cold ends" (this however involves complex structure and is not reliable in the case of a ceramic thermocouple assembly), etc. Practically, none of the proposed solutions has permitted to significantly improve the accuracy of a ceramic thermocouple assembly.

There is therefore a need to improve the accuracy of ceramic thermocouple assemblies using a simple, reliable (independent from the temperature) and practical method.

It has been found that for a thermocouple assembly for the measurement of a temperature comprising first and second ceramic elements contacting each other at a first junction and forming thereby a first thermocouple, this objective can be reached when the assembly also comprises a second thermocouple formed of two different conducting elements (generally metallic conductors) contacting each other at a second junction located on the first ceramic element and a third thermocouple formed of two different conducting elements (generally metallic conductors) contacting each other at a third junction located on the second ceramic element, wherein both positive legs or both negative legs of the second and third thermocouples are connected to a first measuring device, while both legs of the second and third thermocouple are connected respectively to a second and third measuring device.

The inventors have indeed realised that it is impossible to accurately compensate by electronic means only the electromotive forces generated at these cold junctions for a broad range of temperatures and have therefore decided to measure or calculate them exactly and then add or subtract these electromotive forces to calculate the true electromotive force at the hot junction.

According to a first and preferred embodiment of the invention, the first measuring device is an electromotive force readout meter while the second and third measuring devices are thermocouple temperature measuring devices. In that case, the electromotive forces generated at said cold junctions can be calculated by comparing the measured temperature values to experimental data (calibration curve) or theoretical data (polynomial curve).

In another embodiment of the present invention, the first, second and third measuring devices are electromotive force readout meters. Obviously, at the junctions between the two legs of the second and third thermocouples with the connectors of their respective measuring device, unwanted electromotive forces are also generated. Advantageously, the second and third electromotive force readout meters comprise compensating means (for example electronic circuits) for these electromotive forces.

Preferably, the conducting elements of both thermocouple as well as the connectors of their respective electromotive force readout meters are metallic conductors so that conventional cold junction compensating means can be used.

Preferably, the first and second ceramic elements are selected from the group consisting of silicon carbide, titanium nitride, molybdenum disilicide, boron carbide, titanium dioxide, carbon and stabilised zirconia. Advantageously, the first ceramic element comprises molybdenum disilicide and the second ceramic element comprises silicon carbide or titanium nitride.

According to a preferred embodiment of the present invention, the first ceramic element forms an inner leg or and the second ceramic element forms an outer sheath. Thereby, the second ceramic elements protects the first ceramic elements from attacks by the molten phase. In this case, the second ceramic element is generally selected to be suitable to resist the molten phase attacks for a certain time.

In the case of this embodiment, the assembly preferably further comprises an electrically insulating sleeve (preferably constituted of alumina) around the inner leg. This provides electrical insulation and helps to provide rod retention and cushioning from vibration.

In certain case of this preferred variant, it can also be advantageous to have a further sleeve located around the sleeve insulating the inner leg to prevent excessive rod movement (in certain application only).

According to a particular embodiment of the invention, the thermocouple assembly can itself be engaged into a ceramic protective sleeve, for example as described in US-A-4721533.

According to another aspect, the invention relates to a method for the measurement of a temperature comprising
a) introducing a thermocouple assembly according to the present invention into a hot environment, the first junction being positioned at or near the point the temperature of which has to be measured,
b) calculating or measuring the values of the first, second and third electromotive force with the first, second and third measuring devices;
c) calculating the true electromotive force generated at the first (hot) junction by adding or subtracting the calculated or measured electromotive forces generated at the cold junctions;
d) converting the true electromotive force calculated in step c) into a temperature.

For example, if both positive legs of the second and third thermocouples are connected to an electromotive force readout meter, the total electromotive force read on the meter will be equal to the electromotive force generated at the first (hot) junction plus the electromotive force generated at the cold end of the first ceramic element (as calculated or measured using the second measuring device) minus the electromotive force generated at the cold end of the second ceramic element (as calculated or measured using the third measuring device).

The electromotive force generated at the first (hot) junction can thereby be easily assessed and converted into a temperature, for example by comparing this value with a calibration curve or a polynomial expression.

The repetition of steps b) to d) will provide a continuous measurement of the temperature.

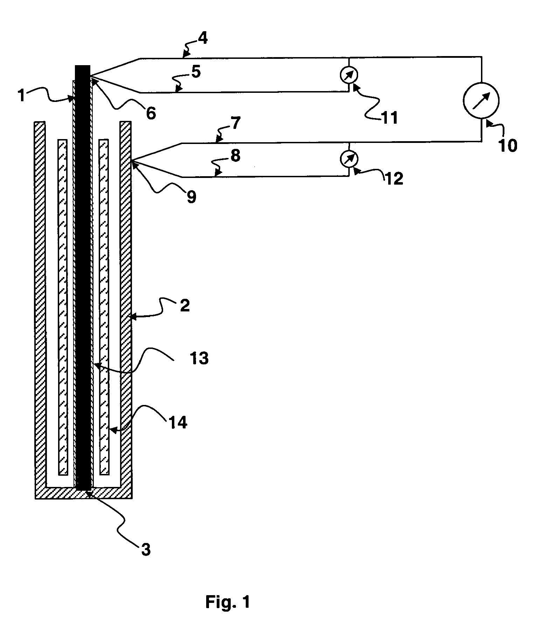

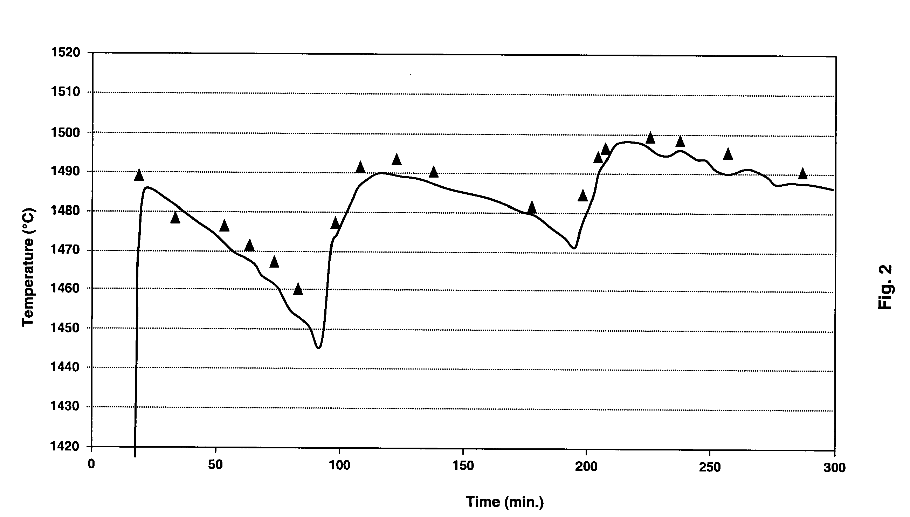

With a view to better define the invention, it will now be described with reference to the enclosed figures; wherein Fig.1 depicts a schematic thermocouple assembly according to the invention and Fig.2 is a diagram showing the temperature determinated with the thermocouple assembly of Fig. 1 using the above described method.

Fig. 1 schematically shows thus a thermocouple assembly for the measurement of the temperature of a molten phase according to the invention. It is constituted of first and second ceramic elements (1,2) contacting each other at a first junction (3) and forming thereby a first thermocouple. In use, the junction (3) is positioned at or under the level of the molten phase. A second thermocouple formed of two different conducting elements (4,5), preferably metallic conductors, contacting each other at a second junction (6) is located on the first ceramic element (1) (preferably around the cold end of the first ceramic element (1)). A third thermocouple formed of two different conducting elements (7,8), preferably metallic conductors, contacting each other at a third junction (9) is located on the second ceramic element (2), (preferably around the cold end of the second ceramic element (2)). Both positive legs (4,7) or both negative legs (5,8) of the second and third thermocouples are connected to a first measuring device (10) (for example, an electromotive force readout meter). Both legs (4,5;7,8) of the second and third thermocouple are connected respectively to a second and third measuring devices (11,12) (for example thermocouple temperature measuring devices).

Thereby, the electromotive forces generated at the cold ends are precisely measured and can be taken into account when determining the true electromotive force generated at the hot junction (3). The electromotive force generated at the hot junction can thereby be easily assessed and converted into a temperature, for example by comparing this value with a calibration curve or a polynomial expression. Quite surprisingly, such an installation can be achieved very simply by using both positive legs (4,7) or both negative legs (5,8) of the second and third thermocouples which are connected to a first electromotive force readout meter (10).

Visible on Fig. 2 is a curve depicting the temperature measured in continuous with the thermocouple assembly according to the invention (continuous line) in a tundish used for the continuous casting of molten steel versus the casting time. The thermocouple assembly was inserted into an alumina-graphite protective sleeve as described in US-A-4721533 and located near the stopper rod controlling the molten steel flow exiting from the tundish. At the beginning of the casting operations (opening of the ladle upstream the tundish), the temperature raises rapidly. The response time of the thermocouple assembly was considered excellent. After about 90 minutes, the temperature of the tundish was around 1450°C; this coincides with the end of the first ladle. A new ladle was brought into position and the temperature raised again with an excellent response time. After another 100 minutes, the second ladle was empty and the third ladle was brought into position and opened. During all the casting operations, parallel temperature determination was performed using a standard thermocouple assembly of the type ACCUMETRIX sold by VESUVIUS USA CORPORATION as disclosed in US-A-4721533 located at the opposite side of the tundish. The temperatures measured with the ACCUMETRIX sensor are depicted as triangles on Fig. 2. It can be seen that the temperatures measured with both systems correspond perfectly all along the casting operations. After use, the thermocouple assembly according to the invention was inspected and no damages was observed.

## Claims

1. A thermocouple assembly for the measurement of a temperature comprising
- first and second ceramic elements (1,2) contacting each other at a first junction (3) and forming thereby a first thermocouple,
- a second thermocouple formed of two different conducting elements (4,5) contacting each other at a second junction (6) located on the first ceramic element (1) and
- a third thermocouple formed of two different conducting elements (7,8) contacting each other at a third junction (9) located on the second ceramic element (2),
wherein both positive legs (4,7) or both negative legs (5,8) of the second and third thermocouples are connected to a first measuring device (10), while both legs (4,5;7,8) of the second and third thermocouple are connected respectively to a second and third measuring device (11,12).

2. A thermocouple assembly according to claim 1 wherein the first measuring device (10) is an electromotive force readout meter and the second and third measuring devices (11,12) are thermocouple temperature measuring devices.

3. A thermocouple assembly according to claim 1 wherein the first, second and third measuring devices (10,11,12) are electromotive force readout meters.

4. A thermocouple assembly according to any one of claims 1 to 3 wherein the conducting elements (4,5,7,8) are metallic conductors.

5. A thermocouple assembly according to any one of claims 1 to 4, wherein the first and second ceramic elements (1,2) are selected from the group consisting of silicon carbide, titanium nitride, molybdenum disilicide, boron carbide, titanium dioxide, carbon, stabilised zirconia.

6. A thermocouple assembly according to any one of claims 1 to 5, wherein the first ceramic element forms an inner leg (1) and the second ceramic element forms an outer sheath (2).

7. A thermocouple assembly according to claim 6, **characterized in that** the assembly further comprises an electrically insulating sleeve (13) around the inner leg (1).

8. A thermocouple assembly according to claim 7, **characterized in that** the electrically insulating sleeve (13) is essentially constituted of alumina.

9. A thermocouple assembly according to claim 7 or 8, **characterized in that** a further sleeve (14) is located around the sleeve (13) insulating the inner leg (1).

10. A thermocouple assembly according to anyone of claims 1 to 9, **characterized in that** the first and second ceramic elements are inserted into a protective sheath.

11. A thermocouple assembly according to claim 10, **characterized in that** the protective sheath is made from alumina graphite.

12. Method for the measurement of the temperature of a molten phase comprising
a) introducing a thermocouple assembly according to any one claims 1 to 11 into a hot environment, the first junction (3) being positioned at or near the point the temperature of which has to be measured,
b) calculating or measuring the values of the first, second and third electromotive force on the first, second and third measuring devices;
c) calculating the true electromotive force generated at the first junction (3);
d) converting the true electromotive force calculated in step c) into a temperature.

13. Method according to claim 12 wherein step d) consists of comparing the true electromotive force calculated in step c) with a calibration curve or a polynomial expression to establish the temperature of the first junction (3).

14. Method according to claim 12 or 13 for the continuous measurement of a temperature comprising the repetition of steps b) to d).
